# FASCICULE DE BREVET EUROPEEN

(11) **EP 0 986 826 B1**
(45) Date de publication et mention de la délivrance du brevet: **29.12.2010**
(21) Numéro de dépôt: 99911878.9
(22) Date de dépôt: 06.04.1999
(51) Int. Cl.: H01L 21/762

(54) **PROCEDE DE TRAITEMENT THERMIQUE DE SUBSTRATS SEMI-CONDUCTEURS**
VERFAHREN ZUR WÄRMEBEHANDLUNG VON HALBLEITERSUBSTRATEN
HEAT TREATMENT METHOD FOR SEMICONDUCTOR SUBSTRATES

(30) Priorité: 07.04.1998 FR 9804299
(43) Date de publication de la demande: 22.03.2000
(73) Titulaire: Commissariat à l'Énergie Atomique et aux Énergies Alternatives, 75015 Paris (FR)
(72) Inventeur: MALEVILLE, Christophe, 38660 La Terrasse (FR); BARGE, Thierry, F-38000 Grenoble (FR); ASPAR, Bernard, F-38140 Rives (FR); MORICEAU, Hubert, F-38120 Saint-Egrève (FR); AUBERTON-HERVE, André-Jacques, 38240 Meylan (FR)
(74) Mandataire: Texier, Christian
(86) Numéro de dépôt international: PCT/FR1999/000786
(87) Numéro de publication internationale: WO 1999/052145

(56) Documents cités:
- EP-A- 0 328 817
- EP-A- 0 444 943
- EP-A- 0 464 837
- US-A- 4 824 698
- US-A- 5 646 053
- PATENT ABSTRACTS OF JAPAN vol. 018, no. 684 (E-1650), 22 décembre 1994 & JP 06 275525 A (SHIN ETSU HANDOTAI CO LTD), 30 septembre 1994
- ABE T ET AL: "ENCAPSULATION OF SURFACE IMPURITIES BY SILICON WAFER-BONDING" JAPANESE JOURNAL OF APPLIED PHYSICS, SUPPLEMENTS,1 janvier 1990, pages 223-226, XP000178042
- PATENT ABSTRACTS OF JAPAN vol. 097, no. 003, 31 mars 1997 & JP 08 316443 A (MITSUBISHI MATERIALS CORP;MITSUBISHI MATERIALS SHILICON CORP), 29 novembre 1996
- AGA H ET AL: "Reduction of defects in thin bonded silicon on insulator (SOI) wafers" PROCEEDINGS OF THE FOURTH INTERNATIONAL SYMPOSIUM ON SEMICONDUCTOR WAFER BONDING: SCIENCE, TECHNOLOGY, AND APPLICATIONS, PROCEEDINGS OF THE FOURTH INTERNATIONAL SYMPOSIUM ON SEMICONDUCTOR WAFER BONDING: SCIENCE, TECHNOLOGY, AND APPLICATIONS, PARIS, F, pages 552-558, XP002085069 ISBN 1-56677-189-7, 1998, Pennington, NJ, USA, Electrochem. Soc, USA

## Description

La présente invention concerne la fabrication de composants semi-conducteurs pour la micro-électronique et/ou l'opto-électronique. Plus précisément, elle concerne le domaine de la fabrication et/ou de la préparation de substrats destinés à la réalisation de tels composants.

Il existe certains procédés de fabrication de substrats, qui consistent à reporter une couche, par exemple de silicium, sur un substrat support.

On connaît par exemple par le document FR 2 681 472, un procédé de fabrication de couches et de films minces de matériau semi-conducteur comprenant au moins trois étapes. Lors d'une première étape, on crée par implantation ionique, une couche de microbulles gazeuses sous une face d'une plaque de matériau semi-conducteur. Lors d'une seconde étape, cette face de la plaque est reportée sur un substrat support et rendue solidaire de celui-ci. Lors d'une troisième étape, l'ensemble constitué par la plaque et le substrat support est soumis à un traitement thermique apte à créer un clivage de la plaque au niveau de la couche d'implantation. Le choix de paramètres tels que le temps et la température de ce traitement thermique dépend de l'historique et du budget thermique de la plaque de semi-conducteur. Ce budget thermique est par exemple acquis au cours de l'étape d'implantation, par chauffage volontaire et/ou par chauffage par le faisceau d'ions lui même. Il peut aussi être acquis au cours d'une étape de recuit qui précède le collage et qui est destinée à faire migrer les atomes implantés en vue de faciliter le clivage ultérieur. Il peut encore être acquis au cours d'un recuit réalisé avant clivage et destiné à stabiliser le collage. D'autres traitements thermiques peuvent encore être envisagés avant le clivage.

Après clivage, on obtient une couche mince adhérant au substrat support. Ce procédé est appelé procédé Smart-Cut^{®}.

Dans une application particulière de ce procédé, dite technique SOI (acronyme de l'expression anglo-saxonne Silicon On Insulator), on réalise une couche de silicium sur isolant. Plusieurs manières peuvent être envisagées pour réaliser une couche de silicium sur isolant, selon le procédé décrit au paragraphe précédent. Selon une première manière, on peut par exemple, recouvrir la plaque de silicium, sur sa face d'implantation, d'une couche d'oxyde isolant, et utiliser un substrat support, par exemple aussi en silicium, pour le report. Selon une deuxième manière, on peut avoir une plaque complètement semi-conductrice que l'on reporte soit sur un substrat support recouvert d'une couche d'isolant, soit sur un substrat support complètement isolant (ex : quartz). Selon une troisième manière, on peut avoir un isolant sur la plaque de semi-conducteur, et reporter cette plaque soit sur un substrat support recouvert lui aussi d'isolant, soit sur un substrat complètement isolant. On remarquera en outre ici, pour obtenir un isolant, l'intérêt d'une étape de formation d'une couche d'oxyde de surface d'une plaque ou d'un substrat support, dans ce cas de silicium, mais plus généralement d'un matériau semi-conducteur.

Après les trois étapes du procédé décrit ci-dessus, des problèmes de décollement de la couche de semi-conducteur sur son substrat support, peuvent survenir. Des défauts présents à l'interface de la couche de semi-conducteur et du substrat support peuvent aussi devenir électriquement actifs et rendre inutilisable la plaquette composée de l'ensemble substrat support-couche de semi-conducteur. Pour pallier ces inconvénients, et plus particulièrement pour éviter un décollement de la couche lorsqu'un polissage est envisagé, il est nécessaire de renforcer l'interface de collage entre le substrat support et la plaque comportant la couche de semi-conducteur.

Il est connu qu'un recuit à des températures relativement élevées, c'est-à-dire supérieures à 1000°C, préférentiellement vers 1100°C, permet de renforcer l'interface de collage. Par la suite, nous désignerons par recuit toute opération thermique destinée à améliorer les qualités du matériau. Ce recuit peut être un traitement thermique effectué à température constante ou à température variable. Dans ce dernier cas, le recuit peut être réalisé par exemple avec une augmentation progressive de la température entre deux valeurs, avec une oscillation cyclique entre deux températures, etc.

Ce type de recuit peut être réalisé sous atmosphère non oxydante ou sous atmosphère oxydante. Un recuit sous atmosphère non oxydante (azote, argon, vide, etc.) présente généralement l'inconvénient de générer un phénomène parasite de piquage, aussi appelé « pitting », à la surface d'un semi-conducteur et du silicium en particulier. Un recuit sous atmosphère oxydante présente l'inconvénient de générer des défauts dans la structure cristalline. Ces défauts sont par exemple du type fautes d'empilement et/ou, dans les structures SOI, défauts HF (on appelle défaut HF, un défaut dont la présence est révélée par une auréole de décoration de l'oxyde enterré, après traitement dans un bain d'acide fluorhydrique), etc.

Par ailleurs, il est parfois utile, pour l'application que nous avons mentionnée plus haut par exemple, de former une couche d'oxyde en surface d'une couche de silicium, par exemple par oxydation. Mais, comme indiqué ci-dessus, une oxydation, mais aussi plus généralement toute formation d'une couche d'oxyde en surface, est connue pour générer des défauts. Or la présence de ces défauts dans la structure cristalline est tout à fait indésirable.

Le document EP 0328817, par exemple, décrit un procédé de réalisation d'une structure SOI par implantation d'ions oxygène dans un substrat faible en silicone pendant le chauffage du substrat pour former une couche de dioxyde de silicone enterrée dans le substrat de silicone. Le substrat est ensuite maintenu à une température supérieure à 1300°C. Les résultats obtenus restent cependant très insuffisants en matière de stabilisation de l'interface de collage entre le substrat et la plaque comportant la couche de semi-conducteur, et la quantité de défauts dans la structure cristalline est trop importante, comme vu précédemment.

Un but de l'invention est de fournir un procédé permettant de réaliser des recuits, notamment de stabilisation de l'interface de collage entre une plaque comprenant une couche de semi-conducteur, notamment de silicium, et un substrat support, sans piquage de la surface de la couche.

Un autre but de l'invention est de fournir un procédé permettant de former une couche d'oxyde à la surface de la couche de semi-conducteur, en limitant le plus possible le nombre de défauts introduits dans la structure cristalline.

Ces buts sont atteints grâce à un procédé de traitement selon la nouvelle revendication 1.

On entend par substrat comportant une couche de semi-conducteur sur au moins une de ses faces, un substrat entièrement semi-conducteur (par exemple du silicium), ou un empilement de couches semi-conductrices, ou encore un substrat comprenant des structures non homogènes ou un substrat comprenant des composants ou des parties de composants à des niveaux plus ou moins avancés de leur élaboration.

A titre d'exemple, les couches de semi-conducteur présentent une épaisseur de quelques dizaines d'Å à quelques dizaines de microns.

Ainsi, grâce au procédé selon l'invention, une couche d'oxyde est formée en surface de la couche de semi-conducteur. Cette couche d'oxyde protège le reste de la couche de semi-conducteur, pendant l'étape de recuit, pour éviter notamment le phénomène de piquage. La couche d'oxyde peut être formée par dépôt d'un oxyde en surface de la couche de semi-conducteur (en particulier, mais pas de manière limitative, pour des semi-conducteurs non oxydables), par oxydation thermique de la zone superficielle de la couche de semi-conducteur ou bien encore par dépôt d'un oxyde en surface de la couche de semi-conducteur, suivi d'une oxydation thermique du semi-conducteur à travers la couche d'oxyde déjà déposée. Dans tous les cas, l'oxyde peut être composé d'éléments du matériau semi-conducteur et d'autres éléments tels que de l'azote, etc.

La combinaison des étapes de formation d'une couche d'oxyde de surface et de recuit, du procédé selon l'invention, permet en particulier d'obtenir un renforcement de l'interface de collage entre la couche de semi-conducteur et le substrat support, en évitant la formation de défauts, et plus particulièrement la formation de défauts du type piquage.

D'autre part, l'étape de recuit du substrat permet de guérir la couche de semi-conducteur des défauts engendrés au cours des étapes précédentes du procédé de fabrication et préparation. Plus particulièrement, l'étape de recuit peut être effectuée pendant une durée et à une température, telles qu'on réalise une guérison de défauts cristallins, tels que des fautes d'empilements, des défauts HF, etc., engendrés dans la couche de semi-conducteur, au cours de l'étape de formation d'une couche d'oxyde de surface. Ainsi, il est possible de former une couche d'oxyde en surface d'une couche de semi-conducteur sans augmenter dramatiquement son taux de défauts. La Demanderesse a en outre découvert que la guérison du matériau semi-conducteur par recuit lui confère une meilleure résistance à d'éventuelles étapes ultérieures de formation d'une couche d'oxyde en surface de la couche de semi-conducteur. En effet, une couche de semi-conducteur comprend moins de défauts après formation d'une couche d'oxyde en surface, lorsqu'elle a subi un recuit, préalablement à la formation de l'oxyde.

Suivant une variante du procédé selon l'invention, celui-ci comprend, après l'étape de recuit, une étape de désoxydation pour ôter la couche d'oxyde formée en surface de la couche de semi-conducteur.

Suivant une autre variante, le procédé selon l'invention comprend plusieurs étapes de formation d'une couche d'oxyde de surface et plusieurs étapes de désoxydation, au moins la dernière étape de formation d'une couche d'oxyde de surface étant suivie d'une étape de recuit.

Mis en oeuvre selon ces deux dernières variantes, le procédé selon l'invention permet en particulier d'amincir la couche de semi-conducteur, d'ôter une partie de la couche de semi-conducteur comportant une concentration importante de défauts ou encore de réduire la rugosité de surface de la couche. Ainsi, le procédé selon l'invention s'avère particulièrement utile, lorsqu'après les étapes d'implantation, collage et clivage du procédé mentionné ci-dessus, on cherche, d'une part à ôter la partie perturbée par l'implantation, c'est à dire au niveau de la zone de clivage (cette partie comporte en effet énormément de défauts), et d'autre part à réduire la rugosité de la surface résultant du clivage. Cette formation d'une couche d'oxyde de surface sacrificielle d'une partie de la couche de semi-conducteur, permet d'éviter les inconvénients d'un polissage seul. La technique du polissage génère en effet, des défauts du type lésion mécanique, des zones écrouies, etc. Lorsqu'on utilise un polissage mécano-chimique, des défauts dus à la chimie peuvent s'ajouter aux précédents. De plus, le polissage aboutit généralement à un manque d'uniformité en épaisseur. Ce dernier inconvénient devient d'autant plus critique que l'épaisseur de matériau à enlever est importante et donc que l'étape de polissage est longue. C'est le cas notamment lorsque l'épaisseur à retirer par polissage atteint 100 nm. Ainsi, tous ces inconvénients aboutissent, le plus souvent, à un manque de reproductibilité des résultats du polissage. De plus, de longs polissages ralentissent l'exécution du procédé et induisent une baisse de productivité. On comprend alors tout l'intérêt de la formation d'une couche d'oxyde de surface sacrificielle, conformément au procédé selon l'invention, puisqu'elle permet de retirer de la matière et d'amincir une couche de semi-conducteur. Si on complète cet amincissement par formation d'une couche d'oxyde de surface sacrificielle d'une étape de polissage, les défauts engendrés par le polissage peuvent alors être développés à moins grande échelle.

Suivant une autre variante, le substrat support recouvert de la couche de semi-conducteur peut être stocké ou livré à un fabricant de composants semi-conducteurs par exemple, avec une couche protectrice d'oxyde qui sera ôtée au moment de la poursuite du traitement du substrat.

D'autres aspects, buts et avantages de l'invention apparaîtront à la lecture de la description détaillée qui suit. L'invention sera aussi mieux comprise à l'aide des références aux dessins sur lesquels :
- la figure 1 représente schématiquement les étapes d'un exemple de mise en oeuvre du procédé de traitement de couches de semi-conducteur, selon l'invention ;
- la figure 2 représente un diagramme d'un exemple d'évolution de la température de chauffage d'un substrat, au cours de son traitement par un procédé conforme à la présente invention ;
- la figure 3 représente un diagramme d'un autre exemple d'évolution de la température de chauffage d'un substrat, au cours de son traitement par un procédé conforme à la présente invention ;
- la figure 4 représente schématiquement les étapes d'un procédé, de l'art antérieur, pour le traitement de substrats pour la micro-électronique et l'opto-électronique ; et
- la figure 5 représente schématiquement les étapes de lissage, suivant le procédé selon l'invention, d'une surface de clivage.

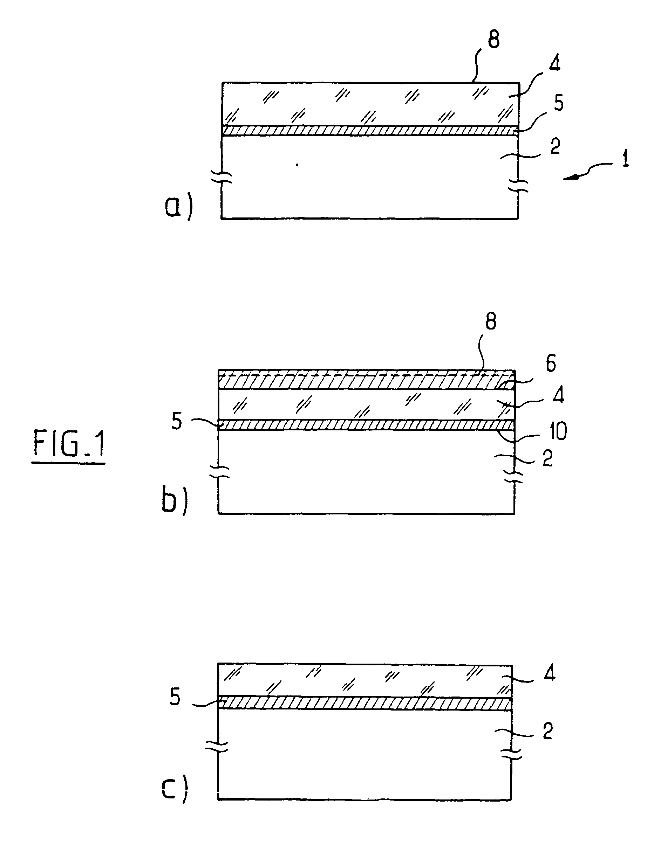

Selon un exemple non limitatif de mise en oeuvre du procédé selon l'invention, illustré par la figure 1, celui-ci est réalisé sur une plaquette 1, comprenant un substrat support 2 recouvert d'une couche de silicium 4, avec une couche intermédiaire d'oxyde enterré 5 (Fig. 1a).

Ce procédé comprend une étape de formation d'une couche d'oxyde de surface pour former une couche d'oxyde de silicium 6 (Fig. 1b), une étape de recuit, et une étape de désoxydation (Fig. 1 c).

Au cours de l'étape de formation de la couche d'oxyde de surface, la couche d'oxyde de silicium 6 se développe au voisinage de la surface initiale 8 de la couche de silicium 4.

La formation d'une couche d'oxyde de surface peut être réalisée par voie sèche ou par voie humide. Par voie sèche, la formation de la couche d'oxyde de surface est produite, par exemple, par chauffage de la plaquette 1 sous oxygène gazeux. Par voie humide, la formation de la couche d'oxyde de surface est produite par exemple par l'intermédiaire de la vapeur d'eau.

Préférentiellement, les étapes de formation de la couche d'oxyde de surface et de recuit, du procédé selon l'invention sont temporellement découplées. Préférentiellement aussi, la température de formation de la couche d'oxyde de surface est comprise entre 900 et 1000°C, car la formation d'une couche d'oxyde de surface génère d'autant moins de défauts dans la structure SOI que sa température est basse. Par contre, l'étape de recuit est avantageusement réalisée à plus de 1000°C.

La formation de la couche d'oxyde de surface par voie humide est préférée car elle introduit moins de défauts du type de ceux déjà mentionnés. La voie humide donne aussi des vitesses de formation de la couche d'oxyde de surface plus élevées que la voie sèche et permet de conserver des cinétiques de formation de la couche d'oxyde de surface raisonnables, tout en travaillant à plus basse température. Préférentiellement, on utilise donc la voie humide, à une température approximativement égale à 950°C, et un recuit à 1100°C, sous atmosphère non oxydante, par exemple sous azote, sous argon, etc.

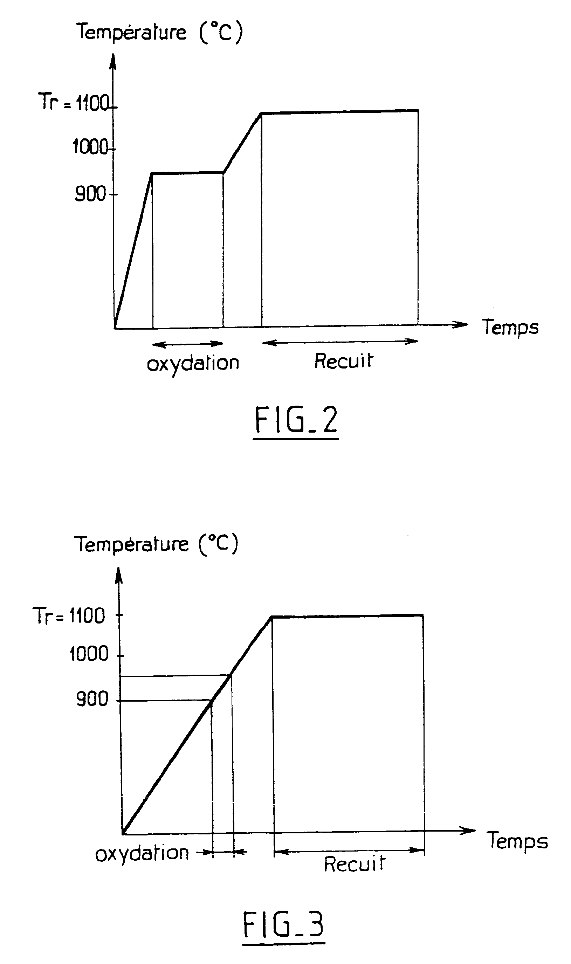

Comme représenté sur la figure 2, la formation d'une couche d'oxyde de surface peut être réalisée pendant un premier palier de température à 950°C et le recuit, à un second palier de température, à *Tᵣ* =1100°C.

Dans certains cas, la plaquette 1 peut être portée à une température d'environ 1200°C. Il peut même être envisagé, par exemple pour stabiliser l'interface de collage 10 entre la couche d'oxyde enterré 5 et le substrat support 2, de mener ce recuit à des températures encore plus élevées, mais des effets indésirables peuvent survenir, telles des contaminations métalliques provenant des équipements de recuit par exemple.

Comme illustré par le diagramme de la figure 3, selon une variante, la formation de la couche d'oxyde de surface peut aussi être réalisée, par exemple, pendant la phase de montée de la température du substrat, jusqu'à la température de recuit *Tᵣ,* à laquelle est effectué un palier.

Dans les exemples de mise en oeuvre illustrés par les figures 2 et 3 et décrits ci-dessus, l'étape de formation de la couche d'oxyde de surface est réalisée avant que l'étape de recuit proprement dite ne commence. Mais selon un autre mode de mise en oeuvre du procédé selon l'invention, la formation de la couche d'oxyde de surface peut être réalisée, à la fois pendant la phase de montée en température du substrat et pendant le début de la phase de recuit. Elle peut aussi être entièrement réalisée pendant le début de la phase de recuit, par exemple en introduisant une quantité dosée d'un gaz oxydant dans l'atmosphère de recuit Préférentiellement, elle est réalisée de telle sorte que la formation de la couche d'oxyde de surface soit achevée avant la fin du recuit.

L'étape de désoxydation est préférentiellement réalisée en immergeant la plaquette 1, dans un bain d'acide fluorhydrique qui présente une bonne sélectivité d'attaque chimique silicium/oxyde de silicium.

Deux exemples d'application de l'invention vont être développés ci-dessous, dans le cadre du procédé Smart-Cut^{®}. Ce procédé est ici utilisé pour fabriquer des structures SOI.

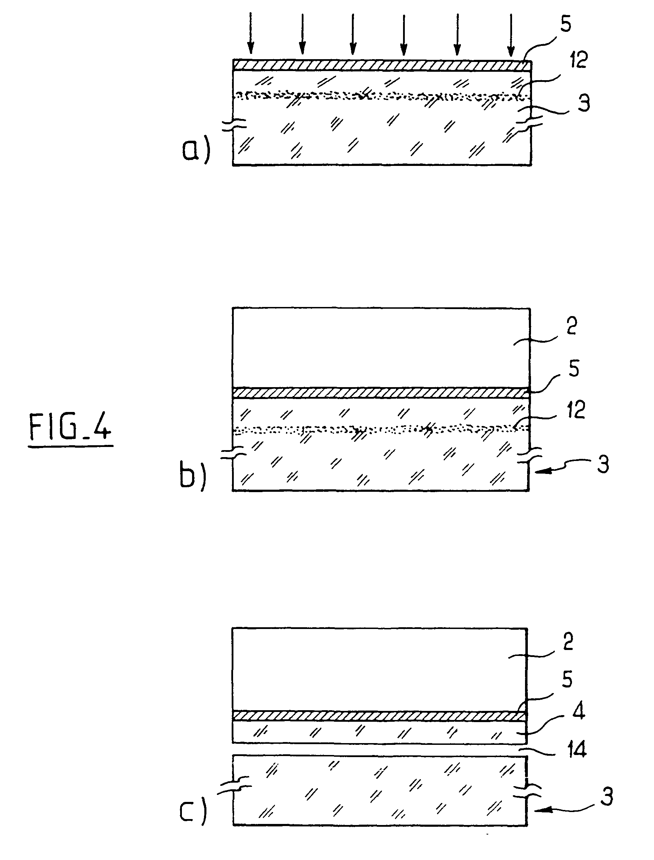

Exemple 1: Le procédé selon l'invention, tel que décrit ci-dessus, peut être effectué pendant une durée et à une température telles, qu'on réalise un renforcement de l'interface de collage 10, entre la couche d'oxyde enterré 5 et le substrat support 2, obtenu après la mise en oeuvre du procédé illustré par la figure 4.

Selon ce procédé, une plaque de silicium 3 recouverte d'une couche d'oxyde enterré est soumise à une implantation d'ions hydrogène, par exemple avec une dose de 5.10¹⁶ H⁺/cm², à 100 keV, dans une zone d'implantation 12, située à une profondeur déterminée (Fig. 4a). Après implantation, la plaque de silicium 3 est mise en contact avec un substrat support 2 (Fig. 4b). L'ensemble comprenant la plaque de silicium 3 et le substrat support 2, subit alors une étape de traitement apte à permettre la séparation de la plaque de silicium 3, au niveau de la zone d'implantation 12 (figure 4c). Cette étape est par exemple réalisée en portant à une température qui dépend des conditions d'implantation et qui peut aller jusqu'à 600°C environ, l'ensemble comprenant la plaque de silicium 3 et le substrat support 2. Selon une variante, des contraintes mécaniques sont appliquées en combinaison avec le traitement thermique ou en remplacement de ce traitement thermique. Après séparation de la couche de semi-conducteur 4 de la plaque 3, on obtient un substrat support 2 recouvert d'une mince couche de silicium 4, avec une couche intermédiaire d'oxyde enterré 5. La surface fibre de cette couche de silicium 4 est une surface de clivage 14.

Il est parfois nécessaire, par exemple avant polissage de la surface de clivage 14 ou pour éviter la formation de défauts électriquement actifs, de procéder à une étape de stabilisation de l'interface de collage 10. Cette stabilisation est obtenue par recuit du substrat à une température voisine, par exemple de 1100°C. Le recuit est réalisé dans une atmosphère comprenant au moins un gaz non oxydant tel que l'argon. Une étape d'oxydation préalable est alors réalisée de préférence au voisinage de 950°C pour former une couche d'oxyde 6 destinée à protéger la couche de silicium 4, pendant ce recuit de stabilisation. Après ce recuit, la couche de silicium 4 subit une étape de désoxydation, destinée à retirer la couche d'oxyde 6 protectrice.

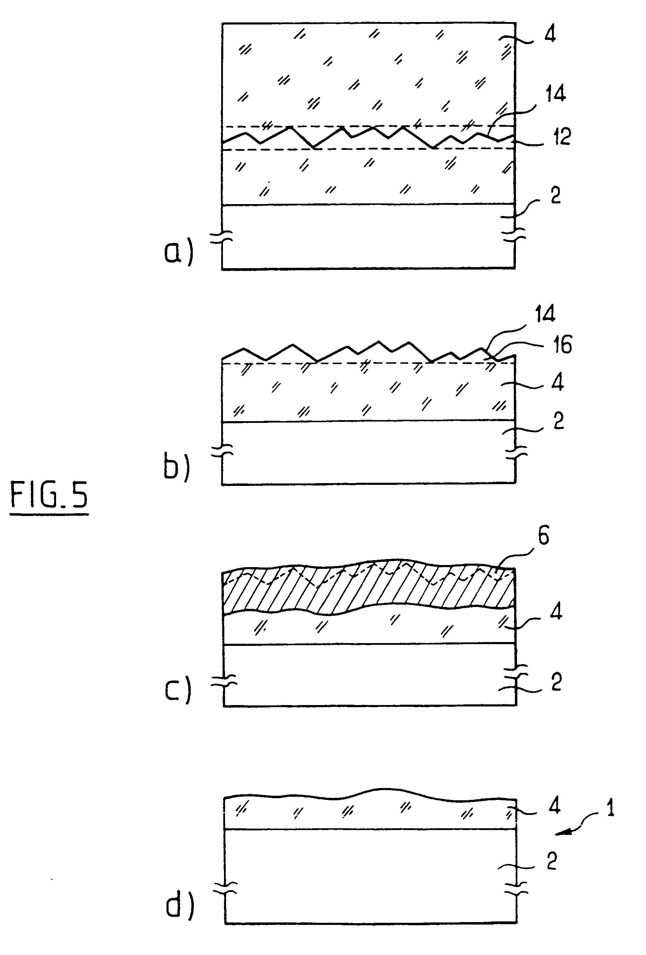

Exemple 2 : Après le clivage du procédé illustré par la figure 4 et déjà décrit dans la présentation du premier exemple, la surface de clivage 14 de la couche de silicium 4 est trop rugueuse et il reste, de manière sous-jacente à cette surface de clivage 14, une zone perturbée 16, correspondant à la partie de la zone d'implantation 12 restante (Figures 5a et 5b). Le procédé selon l'invention peut alors être mis en oeuvre pour retirer cette zone perturbée 16 et retrouver une rugosité convenable. Selon la technique de l'art antérieur, ces opérations sont réalisées par un polissage mécano-chimique. Cependant, un polissage ne donne pas complètement satisfaction puisqu'il présente les inconvénients déjà présentés plus haut. Le procédé selon l'invention y remédie en réalisant une formation d'une couche d'oxyde de surface sacrificielle.

La couche de silicium 4 est oxydée par traitement thermique selon l'une des techniques exposées ci-dessus, pour former une couche d'oxyde 6 (Fig. 5c). Cette couche d'oxyde 6 se développe au voisinage de la surface de clivage 14 et l'interface entre l'oxyde et le silicium progresse en profondeur dans le silicium, en lissant progressivement la rugosité de la surface de clivage 14.

Une étape de recuit conforme au procédé selon l'invention est ensuite opérée.

Puis la couche d'oxyde 6 est consommée par voie chimique (Fig. 5d). A titre d'exemple dans ce cas, pour enlever mille à quelques milliers d'Angströms, la plaquette 1 est plongée dans un bain d'acide fluorhydrique à 10 ou 20 %, pendant quelques minutes.

Les paramètres importants, pour réaliser cette variante du procédé selon l'invention, sont la température, la durée d'oxydation, le caractère oxydant de l'atmosphère et la teneur en oxygène. Ces paramètres peuvent être bien contrôlés. Ce qui confère à cette application du procédé selon l'invention à la formation d'une couche sacrificielle, une bonne reproductibilité. Ce procédé est aussi souple d'utilisation et homogène avec l'ensemble des procédures habituelles de traitement de substrats pour la fabrication de composants pour la micro-électronique.

Le procédé selon l'invention peut aussi présenter au moins une étape de formation d'une couche d'oxyde de surface et au moins une étape de désoxydation, au moins une étape de recuit étant réalisée après la dernière étape de formation d'une couche d'oxyde en surface, afin de guérir les défauts engendrés par la ou les étape(s) de formation d'une couche d'oxyde de surfaces précédentes. Selon une autre variante, le procédé selon l'invention comprend plusieurs étapes de formation d'une couche d'oxyde de surface et plusieurs étapes de désoxydation, chaque étape de formation d'une couche d'oxyde de surface étant suivie d'une étape de recuit.

Les étapes de formation d'une couche sacrificielle, présentées ci-dessus, peuvent être combinées avec une étape de polissage. Cette étape de polissage peut être subséquente ou non des étapes de formation d'une couche sacrificielle. La combinaison de ces étapes peut être employée pour enlever une partie de la couche de silicium présentant une concentration importante de défauts cristallins, situés par exemple dans la zone perturbée par l'implantation ionique. Cette combinaison peut aussi être employée pour diminuer la rugosité. Grâce à la formation d'une couche d'oxyde de surface sacrificielle et à la désoxydation qui lui est associée, le polissage peut alors être très sensiblement moins long et donc moins dommageable pour la couche de silicium 4. Réalisé après la formation et le retrait d'une couche d'oxyde de surface sacrificielle, il est plus efficace, la rugosité difficile à atténuer par un polissage mécano-chimique, ayant déjà été réduite en grande partie.

Selon une variante avantageuse, une étape de formation d'une couche d'oxyde de surface est suivie d'une étape de recuit, ce recuit guérissant les défauts générés par la formation de la couche d'oxyde de surface et stabilisant l'interface de collage 10, une étape de désoxydation, est effectuée après ce recuit, et enfin une étape de polissage court, permet d'achever de réduire la rugosité.

D'une manière générale, le procédé selon l'invention est mis en oeuvre dans le cadre de procédés destinés à effectuer des reports de couches de matériaux sur un substrat support 2 (Smart-Cut^{®}, etc.). Il sert alors à renforcer l'interface de collage des matériaux sur le substrat support 2 et/ou à retirer une couche au voisinage d'un zone très perturbée 16. Le procédé selon l'invention est aussi mis en oeuvre dans le cadre de procédés destinés à réaliser des structures SOI (SIMOX, Smart-Cut^{®}, etc.) ou dans le cadre de l'utilisation de ces structures. Il sert alors à amincir ou oxyder une couche de silicium 4 sans augmenter dramatiquement le taux de défauts, dans cette couche de silicium 4.

Avantageusement encore, le procédé selon l'invention est utilisé pour former une couche d'oxyde 6 localement, sur au moins une partie de la surface de la couche de semi-conducteur 4.

Ce qui a été décrit ci-dessus dans le cas du silicium, peut être transposé à d'autres semi-conducteurs, notamment des composés du silicium tels que SiC, SiGe, etc.

Le procédé selon l'invention permet d'obtenir des structures semi-conductrices de type SOI, dans lesquelles la densité de défauts HF est inférieure à 1 défaut/cm², dans une couche de semi-conducteur 4 dont l'épaisseur est inférieure à 2000 Angströms.

Le procédé selon l'invention permet aussi d'obtenir des structures semi-conductrices dans lesquelles une couche de semi-conducteur 4 ayant une uniformité en épaisseur meilleure que 5 %, a une valeur rms de la rugosité inférieure à 2 nm.

## Revendications

1. Procédé de réalisation d'un substrat (2) comportant une couche de semi-conducteur (4) sur au moins une de ses face comprenant les étapes suivantes: une étape d'implantation d'atomes, sous une face d'une plaque (3) de matériau semi-conducteur, dans une zone d'implantation (12), une étape de mise en contact intime de la face de la plaque (3) soumise à l'implantation avec un substrat support (2), et une étape de traitement apte à permettre la séparation de la plaque (3), au niveau de la zone d'implantation (12), pour séparer la couche de semi-conducteur (4) de la plaque (3) et constituer le substrat (2) comportant cette couche de semi-conducteur (4), et **caractérisé par le fait qu'**il comprend une étape de recuit du substrat (2), une étape de formation d'une couche d'oxyde (6) en surface de la couche de semi-conducteur (4), réalisée avant la fin de l'étape de recuit, protégeant le reste de la couche de semi-conducteur (4).

2. Procédé selon la revendication 1, dans lequel la plaque (3) de silicium est recouverte d'une couche d'oxyde enterré et dans lequel l'implantation d'atomes est une implantation d'ions hydrogène.

3. Procédé selon l'une des revendications 1 et 2, **caractérisé par le fait que** l'étape de formation de la couche d'oxyde (6), est réalisée par oxydation thermique de la couche de semi-conducteur (4).

4. Procédé selon l'une des revendications précédentes, **caractérisé par le fait que** le recuit du substrat est réalisé dans une atmosphère comprenant au moins un gaz non oxydant.

5. Procédé selon la revendication 4, **caractérisé par le fait que** l'au moins un gaz non oxydant est de l'argon.

6. Procédé selon l'une des revendications précédentes, **caractérisé par le fait qu'**il comprend, après l'étape de recuit, une étape de désoxydation pour ôter la couche d'oxyde (6) formée en surface de la couche de semi-conducteur (4).

7. Procédé selon la revendication 6, **caractérisé par le fait qu'**il est utilisé pour mincir la couche de semi-conducteur (4).

8. Procédé selon l'une des revendications précédentes, **caractérisé par le fait qu'**il comprend plusieurs étapes de formation d'une couche d'oxyde (6) de surface et plusieurs étapes de désoxydation, au moins la dernière étape de formation d'une couche d'oxyde (6) de surface étant suivie d'une étape de recuit.

9. Procédé selon l'une des revendications précédentes, **caractérisé par le fait qu'**il comprend en outre une étape subséquente de polissage.

10. Procédé selon l'une des revendications précédentes, **caractérisé par le fait que** le semi-conducteur est du silicium.

11. Procédé selon la revendication 10, **caractérisé par le fait que** chaque étape de recuit est réalisée à plus de 1000°C.

12. Procédé selon la revendication 11, **caractérisé par le fait que** chaque étape de recuit est réalisée à environ 1100°C.

13. Procédé selon l'une des revendications 10 à 12, **caractérisé par le fait que** chaque étape de formation d'une couche d'oxyde (6) est menée à plus basse température que chaque étape de recuit.

14. Procédé selon la revendication 13, **caractérisé par le fait que** chaque étape de formation d'une couche d'oxyde (6) est menée à une température comprise entre 900°C et 1000°C.

15. Procédé selon l'une des revendications précédentes, **caractérisé par le fait que** chaque étape de formation d'une couche d'oxyde (6) de surface est réalisée avant que chaque étape de recuit ne commence.

16. Procédé selon l'une des revendications précédentes, **caractérisé par le fait qu'**au moins une étape de formation d'une couche d'oxyde (6) de surface est réalisée, au moins partiellement, pendant la phase de montée de la température du substrat à la température de recuit.

17. Procédé selon l'une des revendications 1 à 11, **caractérisé par le fait que** chaque étape de formation d'une couche d'oxyde de surface est réalisée, à la même température que celle du recuit, en introduisant une quantité dosée d'un gaz oxydant, dans l'atmosphère de recuit.

18. Procédé selon l'une des revendications précédentes, **caractérisé par le fait que** la couche d'oxyde (6) est formée localement, sur au moins une partie de la surface de la couche de semi-conducteur (4).

## Claims

1. Process for producing a substrate (2) which includes a semiconductor layer (4) on at least one of its faces, comprising the following steps: a step of implanting atoms under one face of a wafer (3) of a semiconductor material in an implantation zone (12), a step of bringing that face of the wafer (3) subjected to the implantation into intimate contact with a support substrate (2), and a treatment step capable of allowing separation from the wafer (3), in the implantation zone (12), in order to separate a semiconductor layer (4) from the wafer (3) and constitute the substrate comprising this semiconductor layer (4), and
**characterized in that** it comprises a step of annealing the substrate (2) and a step of forming an oxide layer (6) on the surface of the semiconductor layer (4), which step is carried out before the end of the annealing, step, protecting the rest of the semiconductor layer (4).

2. Process according to Claim 1, in which the silicon wafer (3) is covered with a buried oxide layer and in which the atom implantation is a hydrogen ion implantation.

3. Process according to either of Claims 1 and 2, **characterized in that** the step of forming the oxide layer (6) is carried out by thermal oxidation of the semiconductor layer (4).

4. Process according to one of the preceding claims, **characterized in that** the substrate is annealed in an atmosphere comprising at least one non-oxidizing gas.

5. Process according to Claim 4, **characterized in that** the at least one non-oxidizing gas is argon.

6. Process according to one of the preceding claims, **characterized in that** it comprises, after the annealing step, a deoxidation step in order to remove the oxide layer (6) formed on the surface of the semiconductor layer (4).

7. Process according to Claim 6, **characterized in that** it is used to thin the semiconductor layer (4).

8. Process according to one of the preceding claims, **characterized in that** it comprises several steps of forming a surface oxide layer (6) and several deoxidation steps, at least the final step of forming a surface oxide layer (6) being followed by an annealing step.

9. Process according to one of the preceding claims, **characterized in that** it furthermore comprises a subsequent polishing step.

10. Process according to one of the preceding claims, **characterized in that** the semiconductor is silicon.

11. Process according to Claim 10, **characterized in that** each annealing step is carried out above 1000°C.

12. Process according to Claim 11, **characterized in that** each annealing step is carried out at about 1100°C.

13. Process according to one of Claims 10 to 12, **characterized in that** each step of forming an oxide layer (6) is carried out at a lower temperature than each annealing step.

14. Process according to Claim 13, **characterized in that** each step of forming an oxide layer (6) is carried out at a temperature between 900°C and 1000°C.

15. Process according to one of the preceding claims, **characterized in that** each step of forming a surface oxide layer (6) is carried out before each annealing step starts.

16. Process according to one of the preceding claims, **characterized in that** at least one step of forming a surface oxide layer (6) is carried out, at least partially, during the phase of raising the temperature of the substrate to the annealing temperature.

17. Process according to one of Claims 1 to 11, **characterized in that** each step of forming a surface oxide layer is carried out, at the same temperature as that of the annealing, by introducing a metered quantity of an oxidizing gas into the annealing atmosphere.

18. Process according to one of the preceding claims, **characterized in that** the oxide layer (6) is formed locally on at least part of the surface of the semiconductor layer (4).

## Patentansprüche

1. Verfahren zur Herstellung eines Substrats (2), das eine Halbleiterschicht (4) auf wenigstens einer seiner Flächen umfasst, welches die folgenden Schritte umfasst: einen Schritt der Implantation von Atomen unter einer Fläche einer Scheibe (3) aus Halbleitermaterial in einem Implantationsbereich (12), einen Schritt des engen Inkontaktbringens der Fläche der Scheibe (3), die der Implantation unterzogen wurde, mit einem Trägersubstrat (2), und einen Bearbeitungsschritt, der ausgelegt ist, die Trennung der Scheibe (3) auf Höhe des Implantationsbereichs (12) zu erlauben, um die Halbleiterschicht (4) von der Scheibe (3) zu trennen und das Substrat (2) zu bilden, das diese Halbleiterschicht (4) umfasst, und
**dadurch gekennzeichnet, dass** es einen Schritt des Glühens des Substrats (2) und einen Schritt der Bildung einer Oxidschicht (6) auf der Oberfläche der Halbleiterschicht (4) umfasst, der vor dem Ende des Schritts des Glühens verwirklicht wird und den Rest der Halbleiterschicht (4) schützt.

2. Verfahren gemäß Anspruch 1, bei dem die Siliziumscheibe (3) mit einer Schicht aus vergrabenem Oxid überzogen ist und bei dem die Atomimplantation eine Implantation von Wasserstoffionen ist.

3. Verfahren gemäß einem der Ansprüche 1 und 2, **dadurch gekennzeichnet, dass** der Schritt der Bildung der Oxidschicht (6) durch thermische Oxidation der Halbleiterschicht (4) verwirklicht wird.

4. Verfahren gemäß einem der vorhergehenden Ansprüche, **dadurch gekennzeichnet, dass** das Glühen des Substrats in einer Atmosphäre verwirklicht wird, die wenigstens ein nichtoxidierendes Gas umfasst.

5. Verfahren gemäß Anspruch 4, **dadurch gekennzeichnet, dass** das wenigstens eine nichtoxidierende Gas Argon ist.

6. Verfahren gemäß einem der vorhergehenden Ansprüche, **dadurch gekennzeichnet, dass** es nach dem Schritt des Glühens einen Desoxidationsschritt umfasst, um die auf der Oberfläche der Halbleiterschicht (4) gebildete Oxidschicht (6) zu entfernen.

7. Verfahren gemäß Anspruch 6, **dadurch gekennzeichnet, dass** es verwendet wird, um die Halbleiterschicht (4) dünner zu machen.

8. Verfahren gemäß einem der vorhergehenden Ansprüche, **dadurch gekennzeichnet, dass** es mehrere Schritte zur Bildung einer Oberflächenoxidschicht (6) und mehrere Desoxidationsschritte umfasst, wobei wenigstens der letzte Schritt zur Bildung einer Oberflächenoxidschicht (6) von einem Schritt des Glühens gefolgt ist.

9. Verfahren gemäß einem der vorhergehenden Ansprüche, **dadurch gekennzeichnet, dass** es außerdem einen anschließenden Polierschritt umfasst.

10. Verfahren gemäß einem der vorhergehenden Ansprüche, **dadurch gekennzeichnet, dass** der Halbleiter aus Silizium ist.

11. Verfahren gemäß Anspruch 10, **dadurch gekennzeichnet, dass** jeder Glühschritt bei mehr als 1000 °C verwirklicht wird.

12. Verfahren gemäß Anspruch 11, **dadurch gekennzeichnet, dass** jeder Glühschritt bei ungefähr 1100 °C verwirklicht wird.

13. Verfahren gemäß einem der Ansprüche 10 bis 12, **dadurch gekennzeichnet, dass** jeder Schritt zur Bildung einer Oxidschicht (6) bei einer niedrigeren Temperatur durchgeführt wird als jeder Glühschritt.

14. Verfahren gemäß Anspruch 13, **dadurch gekennzeichnet, dass** jeder Schritt zur Bildung einer Oxidschicht (6) bei einer Temperatur zwischen 900°C und 1000°C durchgeführt wird.

15. Verfahren gemäß einem der vorhergehenden Ansprüche, **dadurch gekennzeichnet, dass** jeder Schritt zur Bildung einer Oberflächenoxidschicht (6) verwirklicht wird, bevor jeder Glühschritt beginnt.

16. Verfahren gemäß einem der vorhergehenden Ansprüche, **dadurch gekennzeichnet, dass** wenigstens ein Schritt zur Bildung einer Oberflächenoxidschicht (6) wenigstens teilweise während einer Phase des Temperaturanstiegs des Substrats auf die Glühtemperatur verwirklicht wird.

17. Verfahren gemäß einem der Ansprüche 1 bis 11, **dadurch gekennzeichnet, dass** jeder Schritt zur Bildung einer Oberflächenoxidschicht bei derselben Temperatur verwirklicht wird wie der des Glühens, indem eine dosierte Menge eines oxidierenden Gases in die Glühatmosphäre eingeführt wird.

18. Verfahren gemäß einem der vorhergehenden Ansprüche, **dadurch gekennzeichnet, dass** die Oxidschicht (6) lokal auf wenigstens einem Teil der Oberfläche der Halbleiterschicht (4) gebildet wird.
